# EUROPÄISCHE PATENTANMELDUNG

(11) **EP 1 760 493 A2**
(43) Veröffentlichungstag der Anmeldung: **07.03.2007**
(21) Anmeldenummer: 06117974.3
(22) Anmeldetag: 27.07.2006
(51) Int. Cl.: G01V 3/08

(54) **Wanddetektor**

(30) Priorität: 09.08.2005 DE 102005037632
(71) Anmelder: HILTI Aktiengesellschaft, 9494 Schaan (LI)
(72) Erfinder: Würsch, Christoph, 9470, Werdenberg (CH); Kaneider, Wilfried, 6830, Rankweil (AT); Schmitzer, Harald, 9470, Werdenberg (CH)
(74) Vertreter: Wildi, Roland

(57) **Zusammenfassung**

Ein Wanddetektor (1) sowie ein zugeordnetes Messverfahren zur Detektion von einem in einen Untergrund (2) eingebetteten Objekt (3) mit einer Detektionsantenne (5) zur Einbringung von breitbandigen, hochfrequenten elektrischen Wechselfeldern (9) einer Messfrequenz (f_{M}) in den Untergrund (2), mit einem mit der Detektionsantenne (5) verbundenen Messsystem (6) zur Messung der retardierten Wechselwirkung der Wechselfelder (9) mit dem Objekt (3) und mit einem Rechenmittel (7) zur Detektion des Objektes (3) aus dem Messsignal sowie zur Bestimmung der zugeordneten Tiefeninformation, wobei ein Permittivitätsmessmittel (8) mit zumindest einer Zusatzpotentialplatte (11) zur Messung eines Permittivitätsmesssignals des Untergrundes bei einer zur Messfrequenz niederfrequenteren Permittivitätsmessfrequenz (f_{P}) vorhanden ist.

## Beschreibung

### Wanddetektor

Die Erfindung bezeichnet einen Wanddetektor und ein zugeordnetes Messverfahren zur Detektion von in Wänden eingeschlossenen Objekten wie Armierungseisen und Kunststoffrohrleitungen.

Im Baugewerbe eignen sich zur Ortung von Objekten im Untergrund, wie beispielsweise Armierungseisen oder Kunststoffrohrleitungen in Wänden (Seitenwänden, Decken, Böden), Geräte der Radar-Technik (bspw. DE19847688) oder der kapazitiven UWB(Ultra-Wide-Band)-Technologie (bspw. EP1478949). Dabei werden in den zu untersuchenden Untergrund durch eine Detektionsantenne hochfrequente elektrische Wechselfelder eingebracht, deren Wechselwirkung mit den Objekten retardiert auf die Detektionsantenne rückwirkt. Es gibt derartige Geräte mit Messsystemen, die im Frequenzbereich arbeiten und solche, die eher im Zeitbereich arbeiten. Diese bekannten Messsysteme zur Detektion sind als solche nicht Gegenstand der Erfindung, bilden jedoch einen notwendigen Teil dieser.

Gemeinsam ist allen Messsystemen, dass eine grosse Frequenzbandbreite benutzt wird. Diese Bandbreite ist notwendig, um eine ausreichende Tiefenauflösung zu erlangen. Für die Ortung von Objekten im Baugewerbe eignen sich Messfrequenzen im Bandbereich von 0.1 GHz - 10 GHz. Dieser grosse Bandbereich wird deshalb gewählt, weil damit je nach Applikation sowohl eine ausreichende laterale Auflösung, eine ausreichende Tiefenauflösung als auch eine ausreichende Penetration (Messtiefe) erreicht werden kann. Die Wahl der Mittenfrequenz des Frequenzbandes ist somit ein Kompromiss zwischen Auflösung und Messtiefe. Je höher die Frequenz, desto höher die Auflösung, desto höher aber auch die Dämpfung und desto geringer ist die erreichbare Messtiefe.

Die Ausbreitungsgeschwindigkeit v der elektromagnetischen Wechselwirkung in Medien ist gegenüber der der Vakuumlichtgeschwindigkeit c₀ um den Divisor sqrt([epsilon]ᵣ) reduziert, wobei [epsilon]ᵣ die relative Permittivität des Mediums bezeichnet. Um über das Zeitverhalten bzw. Frequenzverhalten der elektromagnetischen Wechselwirkung die Tiefe von Objekten in Untergründen korrekt messen zu können, ist also die Kenntnis der relativen Permittivität des Untergrundes notwendig. Auch wenn der Untergrund (z.B. Beton) immer derselbe ist, kann sich die Permittivität als Funktion der natürlichen Feuchte stark ändern. Trockener Beton hat etwa eine relative Permittivität von [epsilon]_{Beton}≈5, Wasser dagegen hat eine statische relative Permittivität von [epsilon]_{Wasser}≈80. Wegen der hohen Porosität des Betons (und der meisten Baumaterialien wie Ziegel, Leichtbeton, etc.) von etwa 14 Volumen-Prozent, kann Beton auch sehr viel Wasser aufnehmen. Damit ist die Feuchte der dominante Einflussfaktor für die Bestimmung der relativen Permittivität [epsilon]ᵣ des Untergrundes.

Nach der EP1478949 führt ein Wanddetektor zur Detektion von einem in einen Untergrund eingebetteten Objekt mit einer Detektionsantenne zur Einbringung von hochfrequenten elektrischen Wechselfeldern in den Untergrund und einem mit der Detektionsantenne verbundenen Messsystem zur Messung der retardierten Wechselwirkung der Wechselfelder mit dem Objekt und einem Rechenmittel zur Detektion des Objektes aus dem Messsignal sowie zur Bestimmung der zugeordneten Tiefeninformation in einem Verfahrensschritt eine Trennung von Objektsignalanteilen und Untergrundsignalanteilen durch, wobei aus letzteren über eine Korrelation mit Referenzwerten die relative Permittivität des Mediums ermittelt und neben der Phaseninformation des Objektsignalanteils zur Bestimmung der Tiefe des Objekts verwendet wird.

Ein weiterer Einflussfaktor der elektromagnetischen Wechselwirkung ist der Salzgehalt des Untergrundes. Die Salze sind meist im Porenwasser gelöst, was zu einer Leitfähigkeit [sigma] und damit zu ohmschen Verlusten führt, welche zu einer eindringtiefenabhängigen Absorbtion [alpha] der eingebrachten elektromagnetischen Wechselwirkung durch den Untergrund führt. Je höher die Absorbtion [alpha] durch den Untergrund, desto mehr Leistung muss für ein gefordertes Signal-Rauschverhältnis in den Untergrund eingebracht werden, um die notwendige Dynamik für die Detektion tief liegender Objekte zu erreichen.

Nach der DE19915016 wertet ein Radar-Wanddetektor zusätzlich zum Messsignal ein von einer Sendeantenne auf eine lateral beabstandete Empfangsantenne einwirkendes hochfrequentes Übersprechsignal zur Bestimmung der Absorbtion und der Permittivität des Untergrundes aus und regelt die Leistung des Wanddetektors abhängig von der bestimmten Absorbtion.

Die Aufgabe der Erfindung besteht in der Realisierung eines Wanddetektors und eines zugeordneten Verfahrens mit genauer Tiefeninformation.

Die Aufgabe wird im Wesentlichen durch die Merkmale der unanhängigen Ansprüche gelöst. Vorteilhafte Weiterbildungen ergeben sich aus den Unteransprüchen.

So weist ein Wanddetektor zur Detektion von einem in einen Untergrund eingebetteten Objekt mit einer Detektionsantenne zur Einbringung von breitbandigen, hochfrequenten elektrischen Wechselfeldern einer Messfrequenz in den Untergrund und einem mit der Detektionsantenne verbundenen Messsystem zur Messung der retardierten Wechselwirkung der Wechselfelder mit dem Objekt und einem Rechenmittel zur Detektion des Objektes aus dem Messsignal sowie zur Bestimmung der zugeordneten Tiefeninformation, ein Permittivitätsmessmittel mit zumindest einer Zusatzpotentialplatte zur Messung eines Permittivitätsmesssignals des Untergrundes bei einer zur Messfrequenz niederfrequenteren Permittivitätsmessfrequenz auf.

Im zugeordneten Messverfahren zur Detektion von einem in einen Untergrund eingebetteten Objekt mit einem vom Messsystem ausgeführten Messschritt zur Messung der retardierten Wechselwirkung der mit einer Detektionsantenne in den Untergrund eingebrachten breitbandigen, hochfrequenten elektrischen Wechselfelder einer Messfrequenz mit dem Objekt und mit einem vom Rechenmittel ausgeführten Detektionsschritt zur Detektion des Objektes aus dem Messsignal sowie zur Bestimmung der zugeordneten Tiefeninformation wird in einem vom Permittivitätsmessmittel ausgeführten, zeitlich vorgehenden Permittivitätsmessschritt mit einer zur Messfrequenz niederfrequenteren Permittivitätsmessfrequenz ein Permittivitätsmesssignal gemessen und vom Rechenmittel in einem diesem zeitlich nachfolgenden Permittivitätsbestimmungsschritt mittels eines gespeicherten Materialmodells die Permittivität des Untergrundes für die Messfrequenz bestimmt.

Indem ein Permittivitätsmessmittel mit zumindest einer Zusatzpotentialplatte vorhanden ist, welches die Permittivität des Untergrundes über eine zusätzliche, zur Messfrequenz niederfrequentere, Permittivitätsmessfrequenz bestimmt, wird der Einfluss eingebetteter Objekte auf die Permittivitätsbestimmung bereits vom Messansatz her weitgehend unterdrückt, da die niederfrequentere Permittivitätsmessfrequenz sowohl eine wesentlich höhere Penetration des Untergrundes als auch wesentlich geringere Wechselwirkungen mit eingebetteten Objekten aufweist. Aus der daraus über ein genaues Materialmodell mittelbar bestimmten Permittivität des Untergrundes für die Messfrequenz ist somit auch die Tiefeninformation eingebetteter Objekte genau bestimmbar.

Zur Einordnung in den theoretischen Hintergrund wird nachfolgend kurz auf die physikalischen Grundlagen eingegangen. Die auch als relative Dielektrizitätskonstante bezeichnete relative Permittivität [epsilon]ᵣ ist die um Eins vermehrte dielektrische Suszeptibilität der dielektrischen Polarisation und als solche im Kontinuumsbild eine reine Materialeigenschaft, welche jedoch zeit- bzw. frequenzabhängig ist, da sie ursächlich auf der Dynamik von mikrophysikalischen "Körpern" (hier der Ladungsschwerpunkte) beruht. Allgemein sind solche Suszeptibilitäten gut über Relaxatoren - den verallgemeinerten Lösungen hochgedämpfter Bewegungsgleichungen - zu beschreiben. Eine bekannte und insbesondere für Wasser geeignete Lösung ist der DEBYE-Relaxator, welcher einen unabhängigen, idealen Relaxator im homogenen elektrischen Feld beschreibt. Demnach lässt sich die relative Permittivität [epsilon]ᵣ über den Realteil und die Leitfähigkeit über den Imaginärteil einer über viele Dekaden zeit- bzw. frequenzabhängigen komplexen Grösse, der komplexen Permittivität [epsilon]* darstellen, die als solche bspw. über Amplitude und Phase bzw. deren transformierte Grössen experimentell messbar sind. Im Rahmen der Gültigkeit des DEBYE-Modells lässt ist somit bei bekannten Modellparametern aus bei einer niederen Permittivitätsmessfrequenz bestimmten Permittivitätswerten auf solche bei wesentlich (zwei bis drei Dekaden) höheren Messfrequenzen extrapolieren. Entsprechendes gilt für das darauf basierende, spezielle CRI(Complex-Refraction-Index)-Modell, welches zusätzlich die Mischung von porösem Baumaterial und Wasser beschreibt.

Vorteilhaft ist die Permittivitätsmessfrequenz mindestens um zwei Dekaden, weiter vorteilhaft mindestens um drei Dekaden niederfrequenter als die mittlere Messfrequenz, wodurch die Permittivitätsmessung bei geringer Beeinflussung von eingebetteten Objekten und hoher Penetration des Untergrundes erfolgt.

Vorteilhaft ist die zumindest eine Zusatzpotentialplatte symmetrisch (spiegelsymmetrisch oder rotationssymmetrisch) zur Detektionsantenne angeordnet, wodurch der mittlere Ort der Permittivitätsmessung gleich dem Detektionsmessort ist.

Vorteilhaft ist genau eine, mit dem Permittivitätsmessmittel verbundene Zusatzpotentialplatte vorhanden, die mit der als weitere Potentialplatte wirkenden Detektionsantenne einen offenen Kondensator ausbildet, dessen Dielektrikum der Untergrund ausbildet, wodurch die Detektionsantenne mehrfach nutzbar ist.

Vorteilhaft ist die Detektionsantenne über ein Entkopplungsmittel (elektronischer Schalter oder Tiefpassfilter) mit dem Permittivitätsmessmittel verbunden, wodurch das sensible Permittivitätsmessmittel zuverlässig von hochenergetischen hochfrequenten Messsignalen isoliert ist.

Vorteilhaft ist das Permittivitätsmessmittel ein Oszillator, in dessen Schwingkreis oder Brückenzweig die Zusatzpotentialplatten mit dem Untergrund als Dielektrikum eine Messkapazität ausbildet, wodurch die komplexe relative Permittivität einfach über Amplitude und Phasenverschiebung der stationären Schwingung messbar ist.

Alternativ vorteilhaft ist das Permittivitätsmessmittel ein geschalteter QT(Charge-Transfer)-Sensor, bei welchem die Zusatzpotentialplatten mit dem Untergrund als Dielektrikum die gemessene Messkapazität ausbildet, wodurch die relative Permittivität störsicher und hochgenau über geschaltet, nach dem Ladungstransfer-Prinzip aufakkumulierte Spannungsverhältnisse messbar ist. Die Dämpfung wird dabei durch die Verwendung unterschiedlicher Pulsbreiten bestimmt.

Vorteilhaft ist im Messverfahren im Permittivitätsbestimmungsschritt das Materialmodell ein DEBYE-Modell oder ein spezielleres, eine Relaxation beschreibendes Modell (inklusive einer gemessenen Eichkurve), wodurch die Extrapolation der Permittivität und der Absorption über zwei bis drei Dekaden im Frequenz- bzw. Zeitbereich hochgenau möglich ist.

Vorteilhaft wird im Permittivitätsbestimmungsschritt in einem Extrapolationsschritt abhängig von der im Permittivitätsmessschritt gemessenen (komplexen) Permittivität bei einer vorgegebenen Baustoffpermittivität über das eine Stoffmischung berücksichtigende Materialmodell (CRI-Modell oder anderes Mischungsmodell) der Wasseranteil bestimmt, mit welchem als fester Parameter über dieses Materialmodell nachfolgend auf die komplexe Permittivität des Untergrundes bei der Messfrequenz extrapoliert wird, wodurch bezüglich des von der Feuchte abhängigen Wasseranteils deren Relaxationsverhalten berücksichtigt wird.

Vorteilhaft werden in einem dem Extrapolationsschritt nachfolgenden Berechnungsschritt daraus die Ausbreitungsgeschwindigkeit v der elektromagnetischen Wechselwirkung im Untergrund sowie die tiefenabhängige Absorbtion [alpha] berechnet, wodurch die für einen Detektionsschritt mit hochgenauer Tiefenbestimmung sowie optional geregelter Leistung benötigten Parameter bestimmt sind.

Vorteilhaft wird im Permittivitätsbestimmungsschritt in einem zeitlich vorgelagerten Klassifizierungsschritt abhängig von der im Permittivitätsmessschritt gemessenen komplexen Permittivität mittels vorgegebener Klassifikationskriterien eine Zuordnung zu genau einer aus mehreren Baustoffklassen vorgenommen und eine zugeordnete Baustoffpermittivität als fester Parameter ausgewählt, wodurch unterschiedliche Baustoffe berücksichtigt werden.

Vorteilhaft wird in einem nachfolgenden Leistungsregelschritt vom Rechenmittel das Messsystem abhängig von einer extrapolierten Absorbtion [alpha] des Untergrundes bei der Messfrequenz f_{M} und der erforderlichen Messtiefe die Leistung des in den Untergrund einzubringenden elektrischen Wechselfeldes auf einen für eine hinreichende Dynamik notwendigen Leistungswert vorgewählt, wodurch nicht mehr Leistung von der Detektionsantenne in den Untergrund eingebracht werden muss, als zur Messung nötig ist.

Vorteilhaft wird der Permittivitätsmessschritt sowie der nachfolgende Permittivitätsbestimmungsschritt sowie optional der Leistungsregelschritt mehrfach wiederholt, weiter vorteilhaft vor jedem (n-ten) Messschritt, wodurch während einer scannenden Messung mit dem Wanddetektor auftretende Veränderungen des Untergrundes (wechselnde Feuchte etc.) erfasst und bei der Bestimmung der Tiefeninformation detektierter Objekte sowie optional zur Einstellung der Leistung entsprechend berücksichtigt werden.

### Die Erfindung wird bezüglich eines vorteilhaften Ausführungsbeispiels näher erläutert mit:

Fig. 1 als Wanddetektor
Fig. 2 als Variante
Fig. 3 als Materialmodell
Fig. 4 als Algorithmus

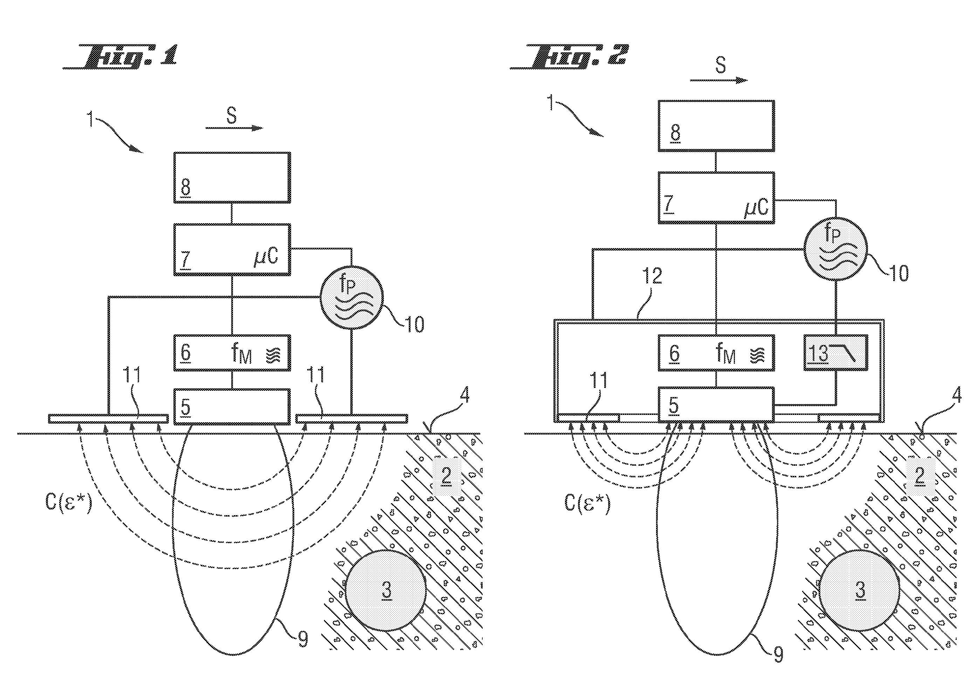

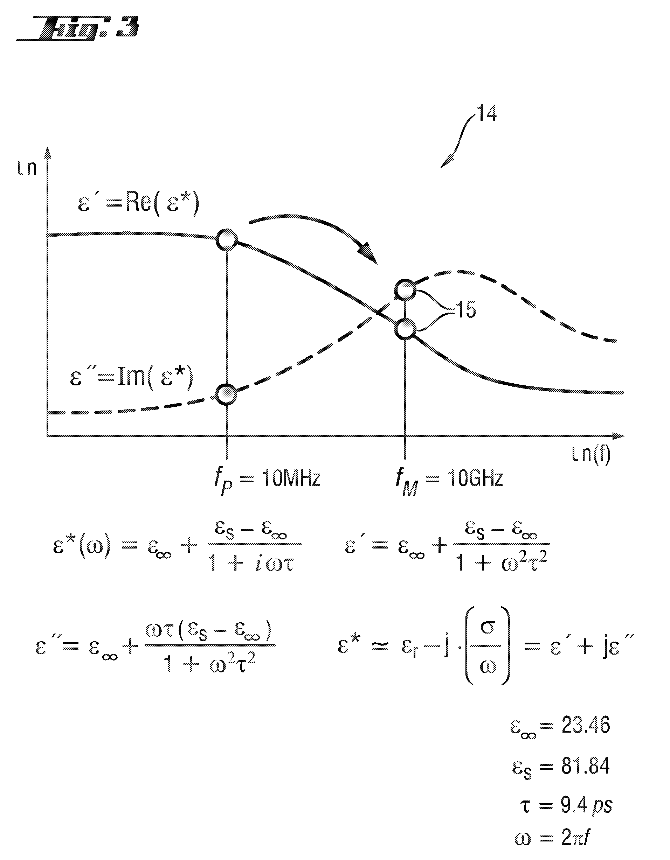

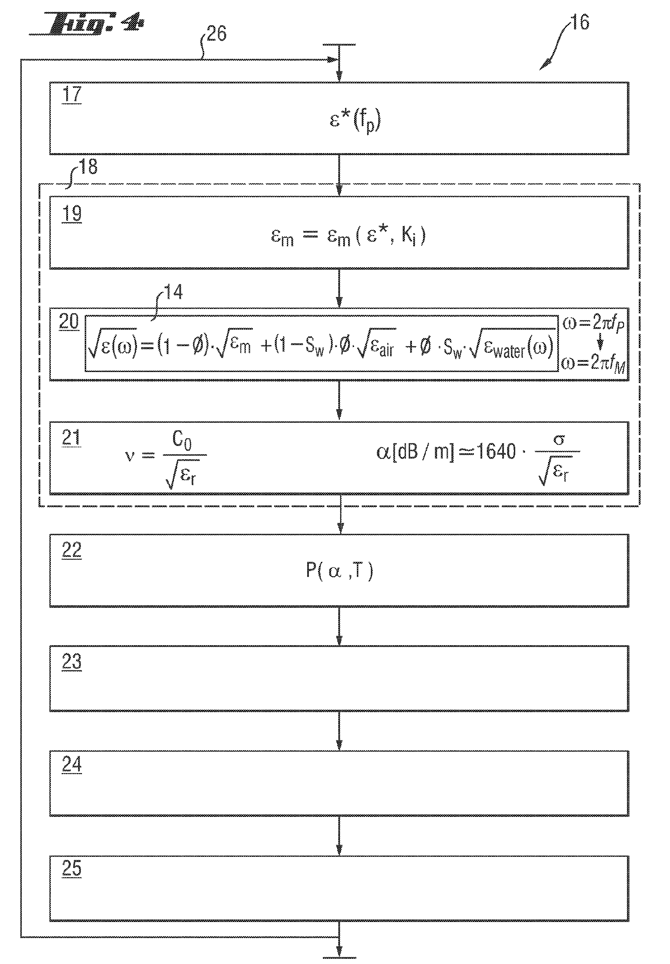

Nach Fig. 1 und Fig. 2 wird ein Wanddetektor 1 zur Detektion von einem in einen Untergrund 2 eingebetteten Objekt 3 längs einer Scannrichtung S scannend über eine Wand 4 bewegt. Seine Detektionsantenne 5 bringt breitbandige, hochfrequente elektrische Wechselfelder 9 gerichtet in den Untergrund 2 ein. Mit der Detektionsantenne 5 ist ein breitbandiges, hochfrequentes Messsystem 6 zur Messung der retardierten Wechselwirkung der gerichteten Wechselfelder 9 einer Messfrequenz f_{M} = 2 GHz mit dem Objekt 3 verbundenen. Ein mit dem Messsystem 6 verbundenes Rechenmittel 7 in Form eines Mikrocontrollers [mü]C dient zur Detektion des Objektes 3 aus dem Messsignal sowie zur Bestimmung der zugeordneten Tiefeninformation des Objektes 3, welche an einem Ein- / Ausgabemittel 8 angezeigt wird. Ein ebenfalls mit dem Rechenmittel 7 verbundenes Permittivitätsmessmittel 10 zur Messung der komplexen Permittivität [epsilon]* des Untergrundes 2 bei einer zur Messfrequenz f_{M} niederfrequenteren Permittivitätsmessfrequenz f_{P} = 10 MHz weist zumindest eine Zusatzpotentialplatte 11 auf, die eine Messkapazität C ausbildet, welche von der komplexen Permittivität [epsilon]* des Untergrundes 2 abhängig ist.

Nach Fig. 1 ist das Permittivitätsmessmittel 10 in Form eines Oszillators mit zwei beidseitig benachbart zur Detektionsantenne 5 angeordneten Zusatzpotentialplatten 11 verbunden, zwischen welchen die Messkapazität C ausgebildet wird.

Nach der Variante in Fig. 2 ist das Permittivitätsmessmittel 10 in Form eines QT-Sensors mit genau einer Zusatzpotentialplatte 11 sowie über ein Entkopplungsmittel 13 in Form eines Tiefpassfilters mit der als weitere Potentialplatte wirkenden Detektionsantenne 5 verbunden, zwischen welchen die Messkapazität C ausgebildet wird. Die Zusatzpotentialplatte 11 ist dabei wandseitig an einer topfförmigen Abschirmung 12 der hochfrequenten Detektionsantenne 5, des Messsystems 6 und des Entkopplungsmittels 13 angeordnet sowie rotationssymmetrisch zur Detektionsantenne 5 ausgebildet.

Nach Fig. 3 beschreibt ein doppellogarithmisch dargestelltes, im Rechenmittel gespeichertes Materialmodell 14 abhängig von der sich über viele Dekaden erstreckenden Frequenz f die komplexe Permittivität [epsilon]*. Dessen Realteil Re([epsilon]') korreliert mit der relativen Permittivität [epsilon]ᵣ und dem Imaginärteil Im([epsilon]") korreliert mit der Leitfähigkeit [sigma]. Der Hochlagen-Tieflagen-Übergang des Realteils Re([epsilon]') und das zugeordnete Maximum des Imaginärteils Im([epsilon]") sind typisch für einen Relaxator. Die dafür angegebenen Formeln und Parameter folgen aus dem DEBYE-Modell für Wasser. Auf Basis dieses Materialmodells 14 wird vom Rechenmittel die bei der Permittivitätsmessfrequenz f_{P} = 10 MHz gemessene komplexe Permittivität [epsilon]* auf einen Extrapolationswert 15 bei der um drei Dekaden höherfrequenten Messfrequenz f_{M} = 10 GHz extrapoliert.

Nach Fig. 4 wird im zugeordneten Messverfahren zur Detektion von einem in einen Untergrund eingebetteten Objekt, welches vom Rechenmittel mit einem implementierten Algorithmus 16 programmgesteuert wird, in einem vom Messsystem ausgeführten Messschritt 23 die retardierte Wechselwirkung der mit einer Detektionsantenne in den Untergrund eingebrachten breitbandigen, hochfrequenten elektrischen Wechselfelder einer Messfrequenz f_{M} mit dem Objekt gemessen. Zeitlich nachfolgend wird in einem vom Rechenmittel ausgeführten Detektionsschritt 24 aus dem Messsignal ein Objekt detektiert und mittels der Ausbreitungsgeschwindigkeit v der elektromagnetischen Wechselwirkung im Untergrund die zugeordnete Tiefeninformation bestimmt und in einem nachfolgenden Ausgabeschritt 25 ausgegeben. Da sowohl der Messschritt 23, der Detektionsschritt 24 als auch der Ausgabeschritt 25 als solche üblich sind und somit kein neues Merkmal der Erfindung darstellen, wird der Fachmann diesbezüglich auf den einschlägigen Stand der Technik, vorzugsweise die in der Beschreibung gewürdigten Druckschriften verwiesen, deren Offenbarungsgehalt hiermit diesbezüglich aufgenommen wird. In einem dem Messschritt 23 zeitlich vorhergehenden Permittivitätsmessschritt 17 wird vom Permittivitätsmessmittel mit der zur Messfrequenz f_{M} niederfrequenteren Permittivitätsmessfrequenz f_{P} ein Permittivitätsmesssignal gemessen und in einem zeitlich nachfolgenden Permittivitätsbestimmungsschritt 18 daraus vom Rechenmittel mittels des gespeicherten Materialmodells 14 die relative Permittivität [epsilon]ᵣ sowie die Absorbtion [alpha] des Untergrundes für die Messfrequenz f_{M} extrapoliert. Dabei wird im Permittivitätsbestimmungsschritt zuerst in einem Klassifizierungsschritt 19 abhängig von der im Permittivitätsmessschritt gemessenen komplexen Permittivität [epsilon]* mittels vorgegebener disjunkter Klassifikationskriterien Kᵢ eine Zuordnung zu genau einer aus i = 1 .. 5 Baustoffklassen vorgenommen und eine zugeordnete trockene relative Baustoffpermittivität [epsilon]ₘ als fester Parameter ausgewählt. Nachfolgend wird in einem Extrapolationsschritt 20 mittels der im Permittivitätsmessschritt 17 gemessenen komplexen Permittivität [epsilon]* für die Permittivitätsmessfrequenz f_{P} über das eine poröse Stoffmischung berücksichtigende Materialmodell 14 in Form eines (jeweils einzeln für den Realteil als auch für den Imaginärteil geltenden) CRI-Modells mit vorgegebener trockener relativer Baustoffpermittivität [epsilon]ₘ, relativer Luftpermittivität [epsilon]ₐᵢᵣ, einer typischen Porösität [Phi] und der relativen Permittivität von Wasser [epsilon]_{water}, welche selbst komplex nach dem DEBYE-Modell modelliert ist (Fig. 3), bei der Permittivitätsmessfrequenz f_{P} ein Wasseranteil S_{w} bestimmt, mit welchem nachfolgend als fester Parameter über dieses Materialmodell auf die komplexen Permittivität [epsilon]* des Untergrundes bei der Messfrequenz f_{M} extrapoliert wird. Damit sind insbesondere über den Realteil auch die relative Permittivität [epsilon]ᵣ sowie über den Imaginärteil die Leitfähigkeit [sigma] des Untergrundes bei der Messfrequenz f_{M} bestimmt (Fig. 3). In einem nachfolgenden Berechnungsschritt 21 werden vom Rechenmittel daraus die Ausbreitungsgeschwindigkeit v der elektromagnetischen Wechselwirkung im Untergrund, die neben der Vakuumlichtgeschwindigkeit c₀ von der relativen Permittivität [epsilon]ᵣ abhängig ist, sowie die tiefenabhängige Absorbtion [alpha] berechnet. In einem nachfolgenden Leistungsregelschritt 22 wird vom Rechenmittel das Messsystem abhängig von der extrapolierten Absorbtion [alpha] des Untergrundes bei der Messfrequenz f_{M} und einer vorgegebenen Messtiefe T die Leistung des in den Untergrund einzubringenden elektrischen Wechselfeldes auf einen für eine hinreichende Dynamik notwendigen Leistungswert P vorgewählt. In einer Schleife 26 wird der Permittivitätsmessschritt 17, der nachfolgende Permittivitätsbestimmungsschritt 18 sowie der Leistungsregelschritt 22 vor jedem Messschritt 23 wiederholt.

## Patentansprüche

1. Wanddetektor zur Detektion von einem in einen Untergrund (2) eingebetteten Objekt (3) mit einer Detektionsantenne (5) zur Einbringung von breitbandigen, hochfrequenten elektrischen Wechselfeldern (9) einer Messfrequenz (f_{M}) in den Untergrund (2), mit einem mit der Detektionsantenne (5) verbundenen Messsystem (6) zur Messung der retardierten Wechselwirkung der Wechselfelder (9) mit dem Objekt (3) und mit einem Rechenmittel (7) zur Detektion des Objektes (3) aus dem Messsignal sowie zur Bestimmung der zugeordneten Tiefeninformation, **dadurch gekennzeichnet, dass** ein Permittivitätsmessmittel (8) mit zumindest einer Zusatzpotentialplatte (11) zur Messung eines Permittivitätsmesssignals des Untergrundes bei einer zur Messfrequenz niederfrequenteren Permittivitätsmessfrequenz (f_{P}) vorhanden ist.

2. Wanddetektor nach Anspruch 1, **dadurch gekennzeichnet, dass** die Permittivitätsmessfrequenz (f_{P}) mindestens um zwei Dekaden, optional mindestens um drei Dekaden, niederfrequenter als die mittlere Messfrequenz (f_{M}) ist.

3. Wanddetektor nach Anspruch 1 oder 2, **dadurch gekennzeichnet, dass** die zumindest eine Zusatzpotentialplatte (11) symmetrisch zur Detektionsantenne (5) angeordnet ist.

4. Wanddetektor nach einem der Ansprüche 1 bis 3, **dadurch gekennzeichnet, dass** genau eine mit dem Permittivitätsmessmittel (8) verbundene Zusatzpotentialplatte (11) vorhanden ist, die mit der als weitere Potentialplatte wirkenden Detektionsantenne (5) einen offenen Kondensator ausbildet, dessen Dielektrikum der Untergrund (2) ausbildet.

5. Wanddetektor nach Anspruch 4, **dadurch gekennzeichnet, dass** die Detektionsantenne (5) über ein Entkopplungsmittel (13) mit dem Permittivitätsmessmittel (8) verbunden ist.

6. Wanddetektor nach einem der Ansprüche 1 bis 5, **dadurch gekennzeichnet, dass** das Permittivitätsmessmittel (8) ein Oszillator ist, in dessen Schwingkreis oder Brückenzweig die Zusatzpotentialplatte (11) mit dem Untergrund (2) als Dielektrikum eine Messkapazität (C) ausbildet.

7. Wanddetektor nach einem der Ansprüche 1 bis 5, **dadurch gekennzeichnet, dass** das Permittivitätsmessmittel (8) ein geschalteter QT-Sensor ist, bei welchem die Zusatzpotentialplatte (11) mit dem Untergrund (2) als Dielektrikum die gemessene Messkapazität (C) ausbildet.

8. Messverfahren zur Detektion von einem in einen Untergrund (2) eingebetteten Objekt (3) mit einem vom Messsystem (6) ausgeführten Messschritt (23) zur Messung der retardierten Wechselwirkung der mit einer Detektionsantenne (5) in den Untergrund (2) eingebrachten breitbandigen, hochfrequenten elektrischen Wechselfelder (9) einer Messfrequenz (f_{M}) mit dem Objekt (3) und mit einem vom Rechenmittel (7) ausgeführten Detektionsschritt (24) zur Detektion des Objektes (3) aus dem Messsignal sowie zur Bestimmung der zugeordneten Tiefeninformation, **dadurch gekennzeichnet, dass** in einem vom Permittivitätsmessmittel (8) ausgeführten, zeitlich vorgehenden Permittivitätsmessschritt (17) mit einer zur Messfrequenz (f_{M}) niederfrequenteren Permittivitätsmessfrequenz (f_{P}) ein Permittivitätsmesssignal gemessen und vom Rechenmittel (7) in einem diesem zeitlich nachfolgenden Permittivitätsbestimmungsschritt (18) mittels eines gespeicherten Materialmodells (14) die relative Permittivität [epsilon]ᵣ des Untergrundes (2) für die Messfrequenz (f_{M}) bestimmt wird.

9. Messverfahren nach Anspruch 8, **dadurch gekennzeichnet, dass** im Permittivitätsbestimmungsschritt (18) das Materialmodell (14) eine Relaxation beschreibt.

10. Messverfahren nach Anspruch 8 oder 9, **dadurch gekennzeichnet, dass** im Permittivitätsbestimmungsschritt (18) in einem Extrapolationsschritt (20) abhängig von einer im Permittivitätsmessschritt (17) gemessenen komplexen Permittivität [epsilon]* bei einer vorgegebenen Baustoffpermittivität [epsilon]ₘ über das eine Stoffmischung berücksichtigende Materialmodell (14) ein Wasseranteil (S_{w}) bestimmt wird, mit welchem als fester Parameter über dieses Materialmodell (14) nachfolgend auf die komplexe Permittivität [epsilon]* des Untergrundes (2) bei der Messfrequenz (f_{M}) extrapoliert wird.

11. Messverfahren nach Anspruch 10, **dadurch gekennzeichnet, dass** in einem dem Extrapolationsschritt (20) nachfolgenden Berechnungsschritt (21) daraus die Ausbreitungsgeschwindigkeit (v) der elektromagnetischen Wechselwirkung im Untergrund (2) sowie die tiefenabhängige Absorbtion ([alpha]) berechnet werden.

12. Messverfahren nach Anspruch 10 oder 11, **dadurch gekennzeichnet, dass** im Permittivitätsbestimmungsschritt (18) in einem zeitlich vorgelagerten Klassifizierungsschritt (19) abhängig von der im Permittivitätsmessschritt (17) gemessenen komplexen Permittivität [epsilon]* mittels vorgegebener Klassifikationskriterien (Kᵢ) eine Zuordnung zu genau einer aus mehreren Baustoffklassen vorgenommen und eine zugeordnete Baustoffpermittivität ([epsilon]ₘ) als fester Parameter ausgewählt wird.

13. Messverfahren nach einem der Ansprüche 8 bis 12, **dadurch gekennzeichnet, dass** in einem nachfolgenden Leistungsregelschritt (22) vom Rechenmittel (7) das Messsystem (6) abhängig von einer extrapolierten Absorbtion ([alpha]) des Untergrundes (2) bei der Messfrequenz (f_{M}) und der erforderlichen Messtiefe (T) die Leistung des in den Untergrund (2) einzubringenden elektrischen Wechselfeldes (9) auf einen für eine hinreichende Dynamik notwendigen Leistungswert (P) vorgewählt wird.

14. Messverfahren nach einem der Ansprüche 8 bis 13, **dadurch gekennzeichnet, dass** der Permittivitätsmessschritt (17) sowie der nachfolgende Permittivitätsbestimmungsschritt (18) mehrfach wiederholt wird, optional vor jedem Messschritt (23).
